# EUROPEAN PATENT APPLICATION

(11) **EP 4 768 928 A1**
(43) Date of publication of application: **01.07.2026**
(21) Application number: 25214946.3
(22) Date of filing: 11.11.2025
(51) Int. Cl.: G01R 31/3185, G01R 31/3177, G01R 31/3181, G01R 31/3173

(54) **BOUNDARY SCAN POWER UP VOLTAGE LEVEL CONFIGURATION**

(30) Priority: 26.12.2024 US 202419002100
(71) Applicant: Altera Corporation, San Jose, CA 95134 (US)
(72) Inventor: LIM, Ching Sia, 11600 Georgetown (MY); EHRLICH, Robert, Round Rock, 78681 (US); XIAO, Ping, E Palo Alto, 94303 (US); GAN, Ann Poh, Selangor (MY); VOON, Wee Sun, 11900 Bayan Lepas (MY); ONG, Andrew Soon Aun, 53300 Wangsa Maju (MY)
(74) Representative: Viering, Jentschura & Partner mbB Patent- und Rechtsanwälte

(57) **Abstract**

Integrated circuit devices, methods, and circuitry for configuring input/output (IO) circuitry for boundary scan chain testing is provided. An integrated circuit device may include a configuration register and IO configuration selector circuitry. The configuration register may define a voltage level of the IO circuitry based on a code stored in the configuration register. The IO configuration selector circuitry may determine the code based on a power-on-reset (POR) instruction.

## Description

### BACKGROUND

This disclosure relates to circuitry to configure a voltage level of input-output circuitry upon power-up to perform boundary scan chain testing of an integrated circuit device.

Integrated circuit devices are found in numerous electronic devices and provide a variety of functionality. To ensure that input/output (IO) circuitry of an integrated circuit device operates properly, manufacturers or customers may perform a form of testing known as joint test action group (JTAG) boundary scan chain testing (e.g., as defined by the IEEE 1149 specification). Many integrated circuits include programmable logic circuitry that may be configured with a hardware system design to implement circuitry that may perform a wide variety of different functions. In many cases, IO circuitry of programmable logic device may be configurable to operate at different voltage levels. To ensure proper operation of the IO circuitry before the programmable logic device is configured, a boundary scan test may be performed.

In certain designs, the IO circuitry may operate according to a default setting across a supported voltage range. The internal voltage for the IO circuitry may also be designed to operate in a subtraction mode, such that the IO circuitry voltage may change according to the supply voltage to the IO circuitry. This solution is feasible for IO circuitry that supports a small operative voltage range (e.g., from 1.0V to 1.5V). However, for IO circuitry that supports a wide range of voltages (e.g., from 1.8V to 3.3V for high voltage input-output (HVIO)), making the IO circuitry functional for all voltage levels by default may incur significant design overhead.

In other designs, configuration of the IO circuitry may be incorporated as a separate step in the boundary scan chain test process. For instance, when sending test commands for boundary scan chain testing, additional commands may be temporarily expanded to access configuration registers of the IO circuitry. Yet this solution involves additional steps in boundary scan chain test loading. Moreover, this may complicate the boundary scan database, since it may involve branching, which may involve different database and chain sequences. It may also complicate the handling on the pintables that show can the boundary scan chain sequence. What is more, this may also increase the chance of making a mistake. If the test owner forgets to unexpand the configuration scan, the next loading may corrupt the boundary scan chain.

### BRIEF DESCRIPTION OF THE DRAWINGS

Various aspects of this disclosure may be better understood upon reading the following detailed description and upon reference to the drawings in which:
FIG. 1 is a block diagram of an integrated circuit device with circuitry to perform a JTAG boundary scan chain test of input/output (IO) subsystems of the integrated circuit device;
FIG. 2 is a block diagram of circuitry in the IO subsystems of the integrated circuit device to support IO voltage level configuration upon power-on-reset (POR);
FIG. 3 is a flowchart of a method for performing IO voltage level configuration upon POR;
FIG. 4 is a block diagram of a JTAG POR instruction that may include an IO voltage level configuration;
FIG. 5 is a table illustrating an IO voltage level configuration provided by the JTAG POR instruction;
FIG. 6 is a circuit diagram of a first example of selection circuitry that may enable an IO subsystem to be configured based on a system design configuration or the JTAG POR instruction;
FIG. 7 is a circuit diagram of a second example of selection circuitry that may enable an IO subsystem to be configured based on a system design configuration or the JTAG POR instruction;
FIG. 8 is a circuit diagram of a third example of selection circuitry that may enable an IO subsystem to be configured based on a system design configuration or the JTAG POR instruction;
FIG. 9 is a circuit diagram of a fourth example of selection circuitry that may enable an IO subsystem to be configured based on a system design configuration or the JTAG POR instruction;
FIG. 10 is a block diagram of another example of a JTAG POR instruction that may include an IO voltage level configuration;
FIG. 11 is a circuit diagram of an example of selection circuitry that may enable an IO subsystem to be configured based on a system design configuration or the JTAG POR instruction of FIG. 10 based on a selection signal from the JTAG POR instruction; and
FIG. 12 is a block diagram of a data processing system that may incorporate the integrated circuit.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. Furthermore, the phrase A "based on" B is intended to mean that A is at least partially based on B. Moreover, the term "or" is intended to be inclusive (e.g., logical OR) and not exclusive (e.g., logical XOR). In other words, the phrase A "or" B is intended to mean A, B, or both A and B.

The circuitry of this disclosure may reduce the time and complexity involved in performing tests of input/output (IO) circuits in an integrated circuit device, such as the Joint Test Action Group (JTAG) boundary scan chain test. The IEEE 1149.1 specification defines circuitry to perform a JTAG boundary scan chain that extends across the IO circuits of the integrated circuit. Some integrated circuit devices include IO subsystems that may support several different voltage levels based on an IO configuration. Yet, in many cases, it may be desirable to perform a boundary scan chain test before the integrated circuit device is fully configured with a system design configuration. This disclosure describes systems and methods to perform boundary scan chain testing upon power-on-reset (POR) before configuration of the programmable logic device and without complex configuration procedures or hardware designs. For example, an instruction used to signal POR may also be used to configure the IO subsystems.

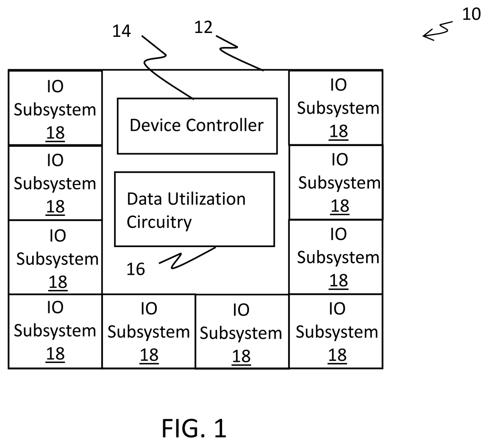

FIG. 1 illustrates a boundary scan chain test system 10 for an integrated circuit 12 that incorporates these innovations. The integrated circuit device 12 may implement a variety of circuitry, such as a processor, an application specific integrated circuit (ASIC), a programmable logic device (PLD) such as a field programmable gate array (FPGA), a memory device, a networking device, a digital signal processing (DSP) device, or any other suitable integrated circuitry. Moreover, the integrated circuit device 12 may represent a single monolithic integrated circuit or may include multiple integrated circuits in a single package or multiple packages.

The integrated circuit device 12 may include a device controller 14 that controls various aspects of the operation of the integrated circuit device 12. In one specific example, the device controller 14 may be a Secure Device Manager (SDM) of a Field Programmable Gate Array (FPGA) by Altera^{®} Corporation (e.g., an Agilex^{™}, Stratix^{®}, Arria^{®}, MAX^{®}, or Cyclone^{®} device by Altera^{®} Corporation). The device controller 14 may enable the integrated circuit 12 to be configured or tested. The device controller 44 may include any suitable logic circuitry to control and/or program the programmable logic 30 or other elements of the integrated circuit device 12. For example, the device controller 44 may include a processor (e.g., an x86 processor or a reduced instruction set computer (RISC) processor, such as an Advanced RISC Machine (ARM) processor or a RISC-V processor) that executes instructions stored on any suitable tangible, non-transitory, machine-readable media (e.g., memory or storage). Additionally or alternatively, the device controller 44 may include a hardware finite state machine (FSM). Data utilization circuitry 16 may include any suitable circuitry to process data, such as a hardened microprocessor, programmable logic circuitry (e.g., programmable logic blocks such as logic array blocks (LABs) or configurable logic blocks (CLBs), programmable routing circuitry, memory, hardened digital signal processing (DSP) blocks), memory, or accelerator circuitry.

The integrated circuit device 12 may also include any suitable number and type of input/output (IO) subsystems 18. Although the IO subsystems 18 are depicted along a shoreline periphery of the integrated circuit device 12, the IO subsystems 18 may be located elsewhere in the integrated circuit device 12. For example, some of the IO subsystems 18 may be disposed within the data utilization circuitry 16 of the integrated circuit device 12 to enable certain circuits of the data utilization circuitry 16 to rapidly communicate with another integrated circuit device within the same package or outside of the package. In the example of FIG. 1, ten IO subsystems 18 are illustrated. However, different versions of the integrated circuit device 12 may include different arrangements and/or types of IO subsystems 18.

The IO subsystems 18 may take any suitable form. For instance, some of the IO subsystems 18 may take the form of a High-Speed Serial Interconnect (HSSI) IO subsystem, while other of the IO subsystems 18 may take the form of a High Voltage Input/Output (HVIO) IO subsystem. The IO subsystems 18 may be configurable to operate at different voltage levels (e.g., 1.8V, 2.5V, 3.3V). In accordance with the IEEE 1149.1 specification, the various IO subsystems 18 of the integrated circuit device 12 share a boundary scan chain that connects all of the IO subsystems 18.

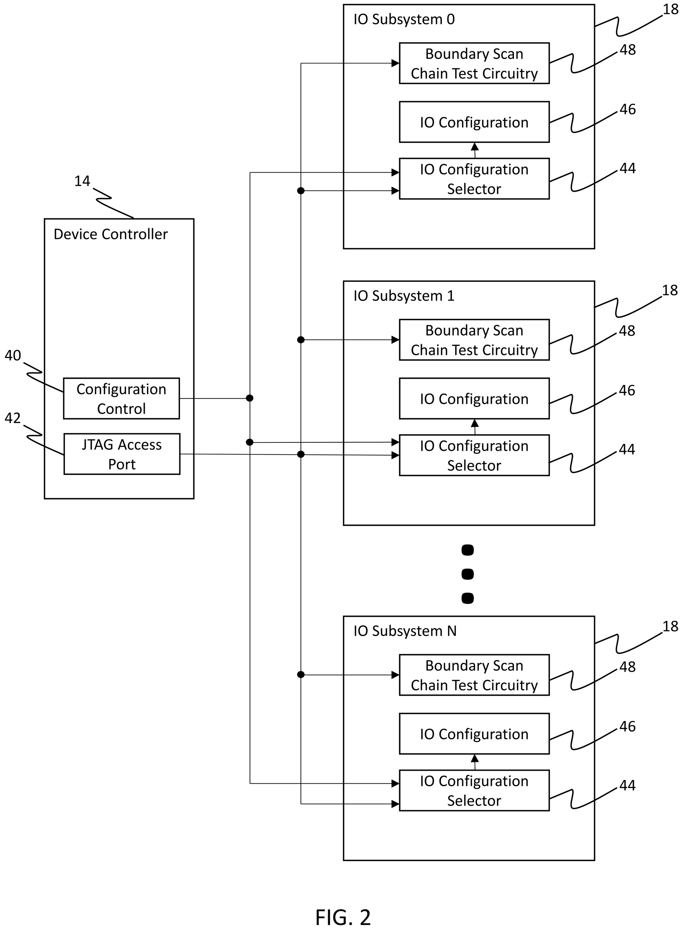

FIG. 2 illustrates circuitry to configure the voltage levels of the IO subsystems 10 before the data utilization circuitry 16 and the IO subsystems 18 are configured with a system design configuration. In FIG. 2, there are N IO subsystems 18 (labeled 0, 1, ..., N) in the boundary scan chain. The device controller 14 may include configuration control circuitry 40 (e.g., a secure device manager (SDM) to program programmable logic circuitry of the integrated circuit device 12) and a JTAG access port 42 (e.g., a main test access port (TAP) of a compact JTAG (CJTAG) system) through which to coordinate a boundary scan chain of the IO subsystems 18.

Although the IO subsystems 18 may be tested in a boundary scan chain test after the configuration control circuitry 40 has configured the integrated circuit device 12 with a system design configuration, it may be desirable to perform the boundary scan chain test before the configuration control circuitry 40 has configured the integrated circuit device 12. As such, the IO subsystems 18 may include an IO configuration selector 44 that may select between a signal deriving from the configuration control circuitry 40 or the JTAG access port 42. Based on the configuration of the IO configuration register 46, the IO subsystems 18 may operate at a particular voltage level (e.g., 1.8V, 2.5V, 3.3V, or other voltage levels). This allows the IO subsystems 18 to be selectively configured based on a system design from the configuration control circuitry 40 (e.g., upon configuration of the integrated circuit device 12) or based on an instruction relating to performing a boundary scan chain test even before the integrated circuit device 12 has been configured. For example, the JTAG access port 42 may issue a power-on-reset (POR) instruction that also includes configuration information to configure the IO subsystems 18 to operate at a particular voltage level. The IO subsystems 18 may also include boundary scan chain test circuitry 48. The boundary scan chain test circuitry 48 may include any suitable circuitry used to test buffers of the IO subsystems 18 according to IEEE 1149.1.

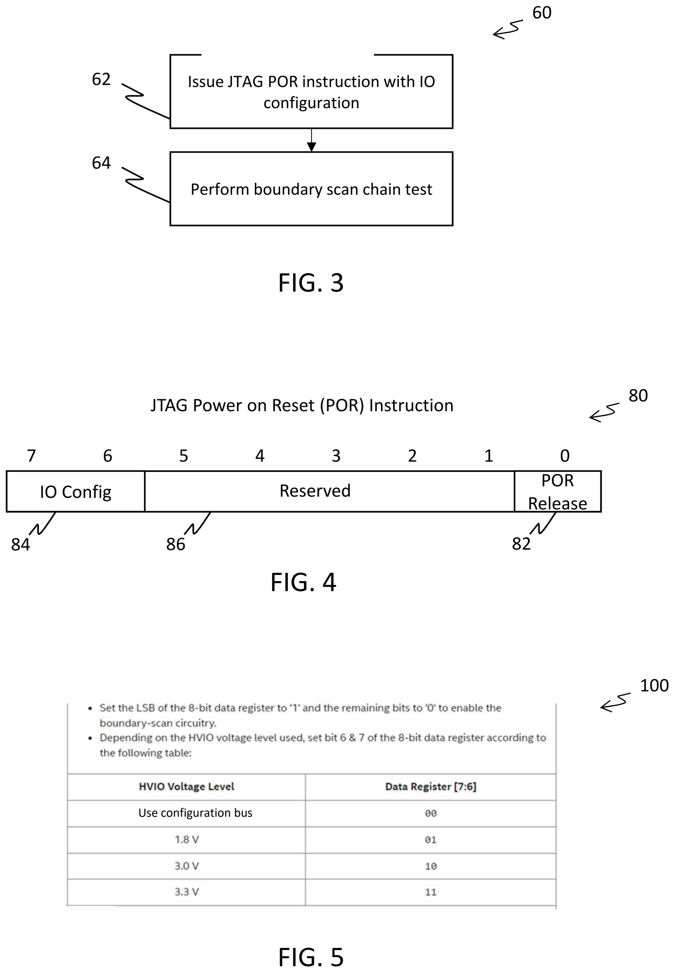

FIG. 3 illustrates a flowchart 60 of a method for performing a boundary scan chain test before the rest of the integrated circuit device 12 is operating or otherwise configured with a system design configuration. When the integrated circuit device 12 is initially powered on, a power-on-reset (POR) may be declared once power is confirmed to be properly available. As such, before a boundary scan chain test of the IO subsystems 18 takes place, the JTAG access port 42 may issue a POR instruction to the IO subsystems 18 (process block 62). Because the POR instruction may be provided in the course of performing a JTAG testing operation, the POR instruction will be referred to in this document as a JTAG POR instruction. However, it should be understood that the POR instruction may not be included as part of the JTAG standard. The JTAG POR instruction indicates to the boundary scan chain test circuitry 48 that a boundary scan chain test may begin (e.g., enables the boundary scan chain test circuitry 48). In addition, the JTAG POR instruction also provides an instruction to set a voltage level configuration in the IO configuration register 46. The IO configuration selector 44 may select the instruction from the JTAG POR instruction from the JTAG access port 42 and configure the IO configuration register 46 with the instructed voltage level configuration. With the IO subsystems 18 configured to operate at the configured voltage level (e.g., 1.8V, 2.5V, 3.3V), a boundary scan chain test may be performed to verify proper operation of the IO subsystems 18 (process block 64).

FIG. 4 is a block diagram of one example of such a JTAG POR instruction 80. The JTAG POR instruction 80 may have any suitable bit width and any suitable fields. In the example of FIG. 4, the JTAG POR instruction 80 includes 8 bits, but in other embodiments, the JTAG POR instruction 80 may include more or fewer. The fields of the JTAG POR instruction 80 may include a POR release field 42 and an IO configuration (IO CONFIG) field 84. The POR release field 42 provides an indication to the IO subsystems 18 that power-on-reset has been achieved (e.g., thereby enabling the IO subsystems 18 to perform a boundary scan chain test). In the example of FIG. 4, the POR release field 42 occupies the least significant bit [0] of the JTAG POR instruction 80. The IO configuration field 84 may cause the IO configuration selector 44 to program the IO configuration register 46 to operate at a defined voltage level (e.g., 1.8V, 2.5V, 3.3V). While the IO configuration field 84 is described in this disclosure as specifying the voltage level as one of three possible voltage levels, the IO configuration field 84 may specify more or fewer voltage levels. In the example of FIG. 4, the IO configuration field 84 occupies bits [7:6] of the JTAG POR instruction 80. Other bits of the JTAG POR instruction 80 may be reserved 86 or may be used for other fields.

FIG. 5 provides a table 100 corresponding to the IO configuration field 84. The table 100 represents one manner in which the IO configuration field 84 may be used to configure the IO subsystems 18 to operate at a particular voltage level. The code specified by the table 100 is used by the IO configuration selector 44 to configure the IO configuration register 46. It should be understood that the code shown in FIG. 5 is provided by way of example and that, in different embodiments, a different code may be used. In the table 100 of FIG. 5, a first code (e.g., "00") in the IO configuration field 84 of the JTAG POR instruction 80 indicates that the IO configuration register 46 is to be configured using a configuration signal provided by the configuration control circuitry 40. A second code (e.g., "01") indicates that the IO configuration register 46 is to be configured to cause the IO subsystem 18 to operate at a first voltage (e.g., 1.8V). A third code (e.g., "10") indicates that the IO configuration register 46 is to be configured to cause the IO subsystem 18 to operate at a second voltage (e.g., 2.5V). A fourth code (e.g., "11") indicates that the IO configuration register 46 is to be configured to cause the IO subsystem 18 to operate at a third voltage (e.g., 3.3V).

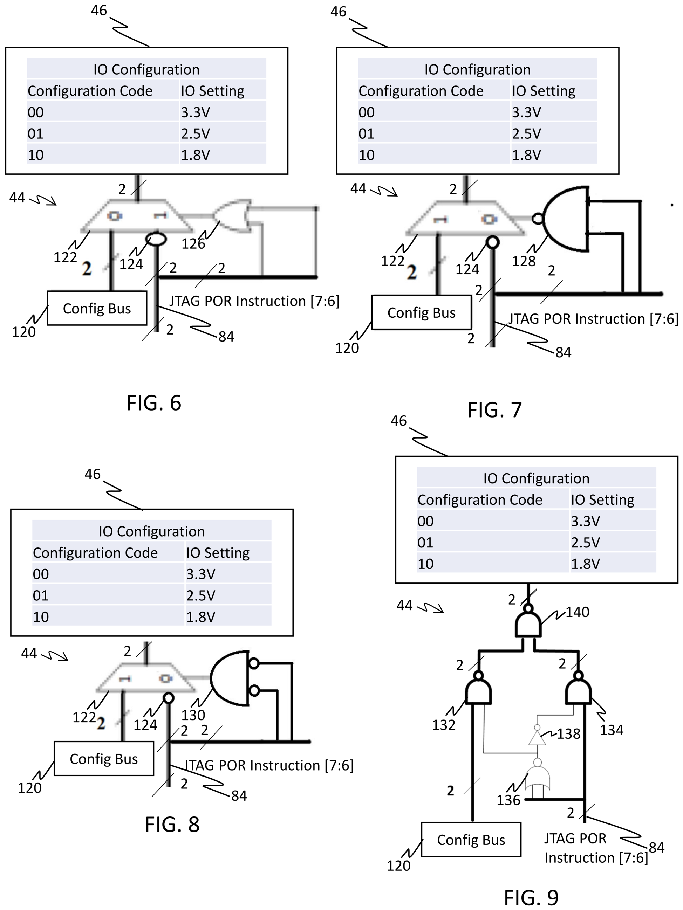

The IO configuration selector 44 to program the IO configuration register 46 based on the IO configuration field 84 of the JTAG POR instruction 80. The IO configuration selector 44 to do so. FIGS. 6-9 provide examples of logic circuitry that may be used to do this. FIGS. 6-9 also illustrate a configuration code of the IO configuration register 46 that corresponds to an IO voltage level setting of the IO subsystems 18. When the IO configuration register 46 includes a first code (e.g., "00") that is the inverse of the fourth code (e.g., "11") of the IO configuration field 84 of the JTAG POR instruction 80 mentioned above, the voltage level setting may be at the third voltage level (e.g., 3.3V). When the IO configuration register 46 includes a second code (e.g., "01") that is the inverse of the third code (e.g., "10") of the IO configuration field 84 of the JTAG POR instruction 80 mentioned above, the voltage level setting may be at the second voltage level (e.g., 2.5V). When the IO configuration register 46 includes a third code (e.g., "10") that is the inverse of the second code (e.g., "01") of the IO configuration field 84 of the JTAG POR instruction 80 mentioned above, the voltage level setting may be at the first voltage level (e.g., 1.8V). Notably, the highest voltage level setting (e.g., the third voltage level, 3.3V) is defined in the IO configuration register 46 by the code "00" in the examples of this disclosure. This means that, by default when the IO configuration register 46 is initialized with zeros or when the IO configuration register 46 is programmed by configuration data from a configuration bus 120 connected to the configuration control circuitry 40 that is initialized with zeros, the IO subsystems 18 may operate at the highest voltage level (e.g., 3.3V) by default.

The IO configuration selector 44 may include any suitable logic circuitry to translate the IO configuration field 84 of the JTAG POR instruction 80 into the appropriate code for the IO configuration register 46. In examples shown in FIGS. 6-8, the IO configuration selector 44 may include a multiplexer 122 that selects between two sets of configuration signals: a normal configuration signal from the configuration bus 120 (or zeros due to an initialization of the configuration bus 120) and an inverted version of the IO configuration field 84 of the JTAG POR instruction 80 by way of an inverter 124. The selection signal to the multiplexer 122 is based on the IO configuration field 84. In FIG. 6, the selection signal is the result of the IO configuration field 84 through an OR gate 126. In FIG. 7, the selection signal is the result of the IO configuration field 84 through a NAND gate 128. In FIG. 8, the selection signal is the result of the inverted IO configuration field 84 through an AND gate 130.

In an example shown in FIG. 9, the IO configuration selector 44 may include other logic circuitry. For instance, the IO configuration selector 44 may include a first NAND gate 132 that receives a configuration signal from the configuration bus 120 and a second NAND gate 134 that receives the IO configuration field 84 of the JTAG POR instruction 80. The IO configuration field 84 may also enter a NOR gate 136, the output of which is supplied to the first NAND gate 132. An inverter 138 may also invert the output of the NOR gate 136 and provide the inverted signal to the second NAND gate 134. Third and fourth NAND gates 140 may receive the outputs of the first NAND gate 132 and the outputs of the second NAND gate 134 and may each output one of the bits of the configuration code. The IO configuration register 46 may be programmed with resulting the signals output by the third and fourth NAND gates 140.

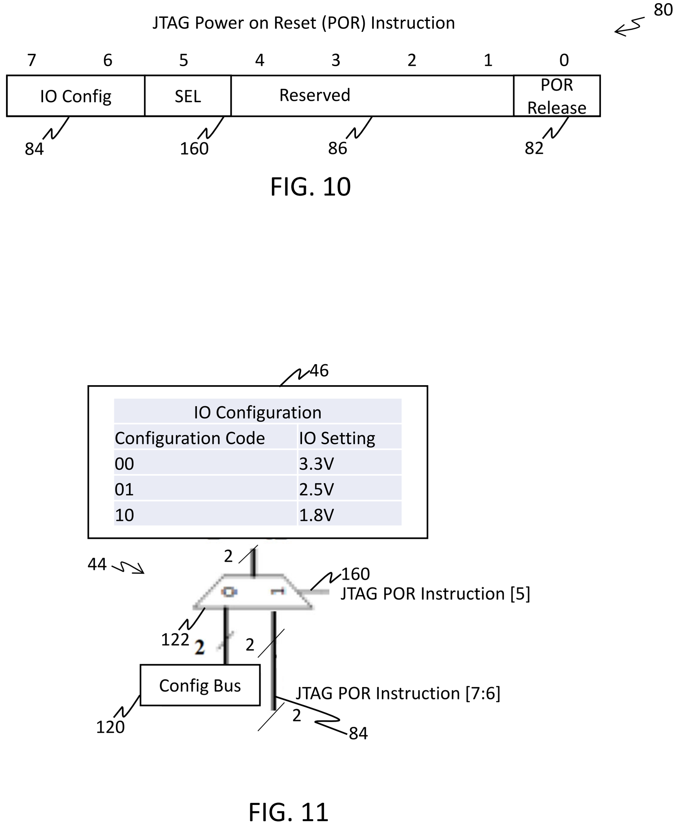

In another example, the selection signal to select between the configuration bus 120 and the IO configuration field 84 of the JTAG POR instruction 80 may be included in the JTAG POR instruction 80 itself. For instance, as shown in FIG. 10, one of the bits of the JTAG POR instruction 80 may act as a selection field 160. While this may consume an additional bit of space of the JTAG POR instruction 80, it may simplify the circuitry of the IO configuration selector 44. In an example shown in FIG. 11, the IO configuration selector 44 may include a multiplexer 122 that selects between two sets of configuration signals: a normal configuration signal from the configuration bus 120 (or zeros due to an initialization of the configuration bus 120) and the IO configuration field 84 of the JTAG POR instruction 80. The multiplexer 122 may select between these signals based on the selection field 160 of the JTAG POR instruction 80.

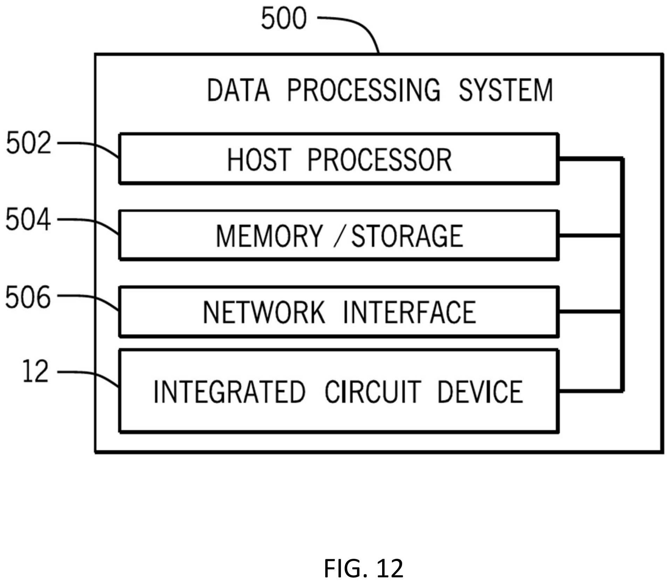

The circuitry of this disclosure may be implemented on any suitable integrated circuit device 12, which may be a component included in a data processing system, such as a data processing system 500, shown in FIG. 12. The data processing system 500 may include the integrated circuit device 12 (e.g., a programmable logic device), a host processor 502, memory and/or storage circuitry 504, and a network interface 506. The data processing system 500 may include more or fewer components (e.g., electronic display, user interface structures, application specific integrated circuits (ASICs)). Moreover, any of the circuit components depicted in FIG. 12 may include the integrated circuit device 12 with the programmable routing bridge 84. The host processor 502 may include any of the foregoing processors that may manage a data processing request for the data processing system 500 (e.g., to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 504 may include random access memory (RAM), read-only memory (ROM), one or more hard drives, flash memory, or the like. The memory and/or storage circuitry 504 may hold data to be processed by the data processing system 500. In some cases, the memory and/or storage circuitry 504 may also store configuration programs (e.g., bitstreams, mapping function) for programming the integrated circuit device 12. The network interface 506 may allow the data processing system 500 to communicate with other electronic devices. The data processing system 500 may include several different packages or may be contained within a single package on a single package substrate. For example, components of the data processing system 500 may be located on several different packages at one location (e.g., a data center) or multiple locations. For instance, components of the data processing system 500 may be located in separate geographic locations or areas, such as cities, states, or countries.

The data processing system 500 may be part of a data center that processes a variety of different requests. For instance, the data processing system 500 may receive a data processing request via the network interface 506 to perform encryption, decryption, machine learning, video processing, voice recognition, image recognition, data compression, database search ranking, bioinformatics, network security pattern identification, spatial navigation, digital signal processing, or other specialized tasks.

The techniques and methods described herein may be applied with other types of integrated circuit systems. For example, the boundary scan chain testing system of this disclosure may be used with central processing units (CPUs), graphics cards, memory devices, hard drives, or other components.

While the embodiments set forth in the present disclosure may be susceptible to various modifications and alternative forms, specific embodiments have been shown by way of example in the drawings and have been described in detail herein. However, the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

### Example Embodiments

EXAMPLE EMBODIMENT 1. An integrated circuit device comprising:
a configuration register configurable to define a voltage level of an input/output (IO) subsystem based on a code stored in the configuration register; and
IO configuration selector circuitry to determine the code based on a power-on-reset (POR) instruction.

EXAMPLE EMBODIMENT 2. The integrated circuit device of example embodiment 1, wherein the IO configuration selector circuitry enables the configuration register to be configured with the code before the integrated circuit device is configured with a system design configuration.

EXAMPLE EMBODIMENT 3. The integrated circuit device of example embodiment 1, wherein the POR instruction comprises a first field corresponding to POR release and a second field that indicates the code.

EXAMPLE EMBODIMENT 4. The integrated circuit device of example embodiment 3, wherein the second field comprises at least two bits.

EXAMPLE EMBODIMENT 5. The integrated circuit device of example embodiment 3, wherein the IO configuration selector circuitry is to use the second field of the POR instruction to select the code based on information in the second field of the POR instruction or based on information from a configuration bus.

EXAMPLE EMBODIMENT 6. The integrated circuit device of example embodiment 1, wherein the code to define the voltage level comprises a code to define the voltage level as one of at least three different possible voltage levels.

EXAMPLE EMBODIMENT 7. The integrated circuit device of example embodiment 6, wherein the code to define the voltage level defines the voltage level as a highest of the at least three different possible voltage levels when programmed with a default value.

EXAMPLE EMBODIMENT 8. The integrated circuit device of example embodiment 1, wherein the integrated circuit device comprises data utilization circuitry comprising programmable logic circuitry configurable with a system design configuration, wherein the IO configuration selector circuitry is to determine the code based on a selection between:
a configuration bus that carries configuration data from the system design configuration; and
a signal based on a first field of the POR instruction.

EXAMPLE EMBODIMENT 9. The integrated circuit device of example embodiment 8, wherein the wherein the IO configuration selector circuitry is to determine the selection based on the first field of the POR instruction.

EXAMPLE EMBODIMENT 10. The integrated circuit device of example embodiment 8, wherein the wherein the IO configuration selector circuitry is to determine the selection based on a second field of the POR instruction separate from the first field of the POR instruction.

EXAMPLE EMBODIMENT 11. The integrated circuit device of example embodiment 8, wherein the signal based on the first field of the POR instruction is an inverted version of the first field of the POR instruction.

EXAMPLE EMBODIMENT 12. A method comprising:
issuing a power-on-reset (POR) instruction that instructs input/output (IO) circuitry to release from POR and that instructs the IO circuitry to operate at a defined voltage level based on the POR instruction; and
performing a boundary scan chain test.

EXAMPLE EMBODIMENT 13. The method of example embodiment 12, wherein the method is performed before a system design configuration is provided to the IO circuitry.

EXAMPLE EMBODIMENT 14. The method of example embodiment 12, wherein the POR instruction comprises a first field that instructs the IO circuitry to release from POR and a second field that instructs the IO circuitry to operate at the defined voltage level.

EXAMPLE EMBODIMENT 15. The method of example embodiment 14, wherein the POR instruction comprises a third field instructs the IO circuitry to use the second field to determine the defined voltage level rather than a configuration signal from a configuration bus.

EXAMPLE EMBODIMENT 16. The method of example embodiment 14, wherein the second field instructs the IO circuitry to use the second field to determine the defined voltage level rather than a configuration signal from a configuration bus.

EXAMPLE EMBODIMENT 17. The method of example embodiment 14, wherein:
the second field instructs the IO circuitry to operate at the defined voltage level according to the following code:
   01 - the defined voltage level comprises a first voltage level corresponding to a lowest defined voltage level of a plurality of defined voltage levels;
   10 - the defined voltage level comprises a second voltage level corresponding to another defined voltage level of the plurality of defined voltage levels higher than the first voltage level; and
   11 - the defined voltage level comprises a third voltage level corresponding to a highest defined voltage level of the plurality of defined voltage levels higher than the second voltage level; and
the IO circuitry operates at the defined voltage level based on a configuration register programmed according to the code:
   10 - the defined voltage level comprises the third voltage level;
   01 - the defined voltage level comprises the second voltage level; and
   00 - the defined voltage level comprises the third voltage level.

EXAMPLE EMBODIMENT 18. Circuitry comprising:
a multiplexer to select between a first configuration signal based on configuration data from a configuration bus and a second configuration signal based on a power-on-reset (POR) signal; and
a configuration register corresponding to an operating voltage of input/output (IO) circuitry, wherein the configuration register is configurable to be programmed with the first configuration signal or the second configuration signal.

EXAMPLE EMBODIMENT 19. The circuitry of example embodiment 18, wherein the multiplexer comprises a selection signal based on the POR signal.

EXAMPLE EMBODIMENT 20. The circuitry of example embodiment 19, comprising logic circuitry to generate the selection signal based on a portion of the POR signal.

## Claims

1. An integrated circuit device comprising:
a configuration register configurable to define a voltage level of an input/output (IO) subsystem based on a code stored in the configuration register; and
IO configuration selector circuitry to determine the code based on a power-on-reset (POR) instruction.

2. The integrated circuit device of claim 1, wherein the IO configuration selector circuitry enables the configuration register to be configured with the code before the integrated circuit device is configured with a system design configuration.

3. The integrated circuit device of any of the preceding claims, wherein the POR instruction comprises a first field corresponding to POR release and a second field that indicates the code.

4. The integrated circuit device of claim 3, wherein the second field comprises at least two bits.

5. The integrated circuit device of claim 3 or 4, wherein the IO configuration selector circuitry is to use the second field of the POR instruction to select the code based on information in the second field of the POR instruction or based on information from a configuration bus.

6. The integrated circuit device of any of the preceding claims, wherein the code to define the voltage level comprises a code to define the voltage level as one of at least three different possible voltage levels.

7. The integrated circuit device of claim 6, wherein the code to define the voltage level defines the voltage level as a highest of the at least three different possible voltage levels when programmed with a default value.

8. The integrated circuit device of any of the preceding claims, wherein the integrated circuit device comprises data utilization circuitry comprising programmable logic circuitry configurable with a system design configuration, wherein the IO configuration selector circuitry is to determine the code based on a selection between:
a configuration bus that carries configuration data from the system design configuration; and
a signal based on a first field of the POR instruction.

9. The integrated circuit device of claim 8, wherein the wherein the IO configuration selector circuitry is to determine the selection based on the first field of the POR instruction.

10. The integrated circuit device of claim 8 or 9, wherein the wherein the IO configuration selector circuitry is to determine the selection based on a second field of the POR instruction separate from the first field of the POR instruction.

11. The integrated circuit device of any of claims 8-10, wherein the signal based on the first field of the POR instruction is an inverted version of the first field of the POR instruction.

12. A method comprising:
issuing a power-on-reset (POR) instruction that instructs input/output (IO) circuitry to release from POR and that instructs the IO circuitry to operate at a defined voltage level based on the POR instruction; and
performing a boundary scan chain test.

13. The method of claim 12, wherein the method is performed before a system design configuration is provided to the IO circuitry.

14. The method of claim 12 or 13, wherein the POR instruction comprises a first field that instructs the IO circuitry to release from POR and a second field that instructs the IO circuitry to operate at the defined voltage level.

15. The method of claim 14, wherein the POR instruction comprises a third field instructs the IO circuitry to use the second field to determine the defined voltage level rather than a configuration signal from a configuration bus.
